# FASCICULE DE BREVET EUROPEEN

(11) **EP 3 331 336 B1**
(45) Date de publication et mention de la délivrance du brevet: **23.10.2019**
(21) Numéro de dépôt: 17205406.6
(22) Date de dépôt: 05.12.2017
(51) Int. Cl.: H05K 7/14, B60L 15/00, H02G 5/02, H02M 7/00

(54) **SYSTÈME COMPACT D'ÉLECTRONIQUE DE PUISSANCE POUR GROUPE MOTOPROPULSEUR ÉLECTRIQUE**
KOMPAKTES LEISTUNGSELEKTRONIKSYSTEM FÜR ELEKTRISCHE MOTORANTRIEBSANLAGE
COMPACT POWER ELECTRONICS SYSTEM FOR ELECTRIC POWERTRAIN

(30) Priorité: 05.12.2016 FR 1661939
(43) Date de publication de la demande: 06.06.2018
(73) Titulaire: RENAULT s.a.s., 92100 Boulogne-Billancourt (FR)
(72) Inventeur: MARIOTTE, Yann, 91070 Bondoufle (FR); LEBIGRE, Richard, 76100 Rouen (FR)

(56) Documents cités:
- EP-A1- 1 786 080
- FR-A1- 2 308 173
- FR-A1- 3 033 092
- US-A1- 2014 111 003

## Description

La présente invention se rapporte de manière générale au domaine de l'électrotechnique et concerne plus précisément un système d'électronique de puissance pour groupe motopropulseur électrique.

Dans certains véhicules électriques ou hybrides de petit gabarit, on cherche à réduire l'encombrement des éléments du groupe motopropulseur électrique présents dans le compartiment moteur. Dans un tel groupe motopropulseur, on utilise notamment des barres bus pour connecter entre eux les différents modules de puissance qui permettent notamment d'alimenter le moteur électrique à partir de la batterie de traction du véhicule.

On rappelle qu'une barre bus est un conducteur électrique rigide destiné à être parcouru par des courants de forte intensité. Elle se présente généralement comme une bande de section rectangulaire, par exemple en cuivre ou en aluminium, connectée à chacune de ses extrémités à un module électronique de puissance tel qu'un module onduleur ou un module capacitif. Les connexions électriques de la barre bus sont en général effectuées par vissage.

Or l'agencement des barres bus est soumis à des contraintes dues notamment aux courants parasites engendrés par le champ magnétique des courants de l'ordre de dizaines d'ampères traversant ces barres bus, mais aussi aux vibrations causées par le groupe motopropulseur en fonctionnement et par des phénomènes de résonance des barres bus lorsque celles-ci sont parcourues par des courants hachés.

Ainsi il a été constaté par les inventeurs qu'en dessous de 200Hz une barre bus pouvait entrer en résonance et rompre sa fixation sur l'onduleur qui lui fournissait un courant haché de forte intensité. Afin de remédier à cet effet, il est envisagé de solidariser les barres bus parcourues par des courants de sens contraires.

Le document FR3033092 propose un dispositif de maintien de barres bus en matière plastique, permettant de contenir deux barres bus parcourues par des courants de sens contraires reliant deux modules de puissance distincts, et de les solidariser sur organe externe pour déplacer la fréquence de résonance de ces barres bus. Ce dispositif permet de maintenir ces barres bus de façon superposés, ce qui permet de limiter les courants parasites. Cependant, l'assemblage des barres bus dans ce dispositif s'est avéré compliqué et le maintien des barres bus dans ce dispositif ne permet pas de réduire assez les diverses vibrations auxquelles elles sont soumises.

Un des buts de l'invention est de remédier à au moins une partie des inconvénients de la technique antérieure en fournissant un système d'électronique de puissance pour groupe motopropulseur électrique, qui soit compact et permette de maîtriser les vibrations auxquelles sont soumises les barres bus de ce groupe motopropulseur électrique.

A cette fin, l'invention propose un système d'électronique de puissance pour groupe motopropulseur électrique, comportant :
- un premier module d'électronique de puissance
- un deuxième module d'électronique de puissance,
- un troisième module d'électronique de puissance,
- un ensemble de barres bus connectant ledit premier module audit deuxième module,
ledit système étant caractérisé en ce que ledit ensemble de barres bus comporte une déviation en forme de U prise en sandwich entre le carter du troisième module et une agrafe fixée audit carter, seul un bloc de mousse composite isolante séparant ledit carter dudit ensemble de barres bus.

Ce système d'électronique de puissance permet de déplacer facilement la fréquence de résonance des barres bus en déplaçant la position de l'agrafe sur la déviation en forme de U, et offre une très bonne tenue vibratoire grâce à une fixation mécanique très stable entre les barres bus et le troisième module de puissance. En effet les inventeurs ont constaté qu'il était possible de fixer directement les barres bus sur un module de puissance avec seulement une mousse composite les séparant, malgré la température des barres bus qui peut atteindre 100°C en fonctionnement et dont on aurait pu penser qu'elles auraient dégradé le troisième module de puissance au point de réduire significativement sa durée de vie.

Selon une caractéristique avantageuse du système selon l'invention, ladite agrafe est une patte en plastique avec un insert en laiton fixée par vissage sur un bossage dudit carter, ladite patte étant seulement isolée dudit ensemble de barres bus par un bloc de mousse composite isolante.

Cette conception de l'agrafe permet une fabrication de celle-ci et un montage des barres bus dans celle-ci plus simples que dans l'art antérieur. De plus elle permet une fabrication peu onéreuse.

Selon une autre caractéristique avantageuse de l'invention, ledit ensemble de barres bus comporte une barre bus parcourue par un courant positif et une barre bus parcourue par un courant négatif superposées au niveau de ladite agrafe, et séparées par un bloc de mousse composite isolante.

Cette disposition augmente la compacité du système d'électronique de puissance, et diminue les pertes électriques du système.

Selon encore une autre caractéristique avantageuse de l'invention, ledit troisième module est disposé dans le U et comporte une connexion électrique formée de deux barres bus sensiblement parallèles à l'une des pattes dudit U, ladite connexion électrique venant se connecter sur le même bornier que ledit premier module ou ledit troisième module.

Cette disposition augmente encore la compacité du système électrique tout en diminuant ses pertes électriques.

Selon enfin une autre caractéristique avantageuse de l'invention, le premier module est un module onduleur, le deuxième module est un module de conversion courant continu - courant continu, et le troisième module est un module capacitif hébergeant une capacité de lissage destinée à être connectée aux bornes d'une batterie dudit groupe motopropulseur électrique.

Ces connexions entre les modules de puissance permettent de rationaliser les connexions à la batterie du groupe motopropulseur et partant de diminuer les pertes électriques du système d'électronique de puissance.

D'autres caractéristiques et avantages apparaîtront à la lecture d'un mode de réalisation préféré décrit en référence aux figures dans lesquelles :
- la figure 1 représente une vue en perspective d'un système d'électronique de puissance selon l'invention, dans ce mode de réalisation préféré,
- et la figure 2 représente une vue en perspective depuis un angle différent de ce système d'électronique de puissance selon l'invention.

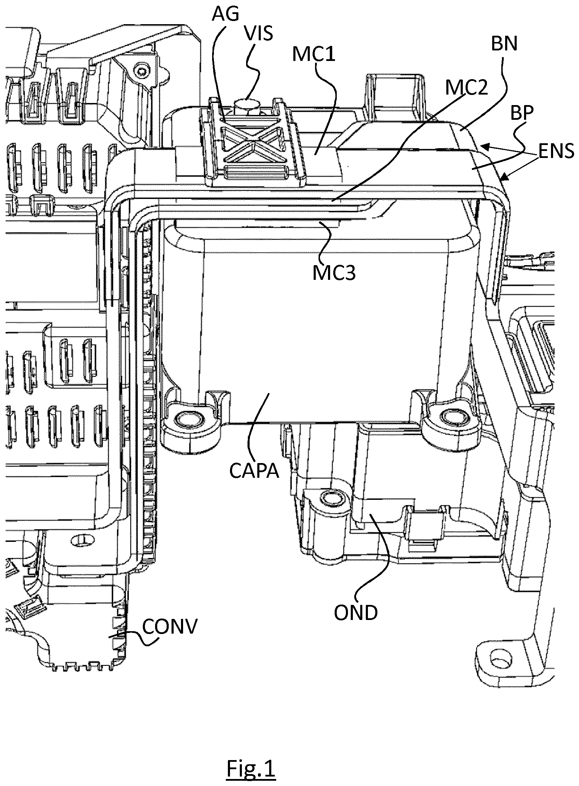

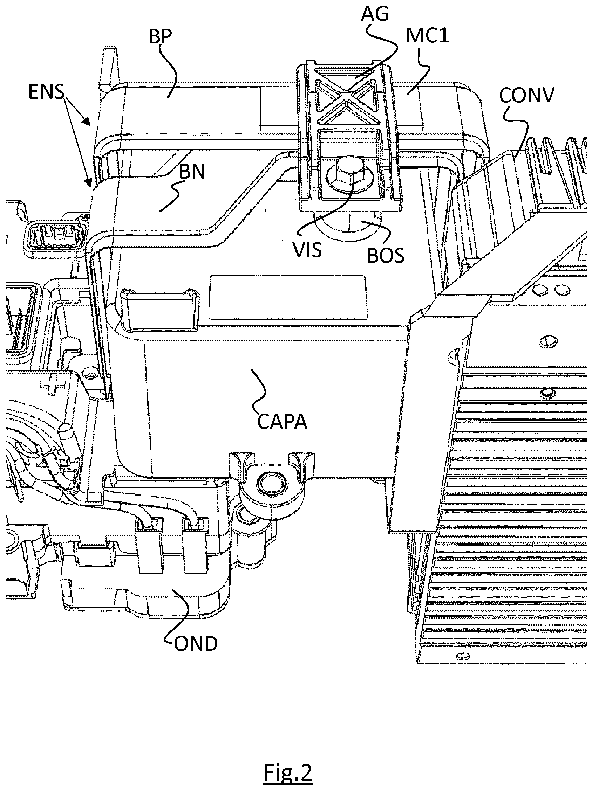

Selon un mode préféré de réalisation de l'invention représenté aux **figures 1** **et** **2****,** le système d'électronique de puissance selon l'invention comprend :
- un premier module de puissance OND, qui est un module onduleur hébergeant un onduleur de courant. Ce module onduleur est connecté à la batterie de traction d'un véhicule électrique ou hybride, et permet d'alimenter un moteur électrique triphasé de traction ; par batterie de traction on entend une batterie d'accumulateurs apte à alimenter un moteur électrique fournissant du couple à la roue, que ce moteur soit utilisé en propulsion ou en traction. Il s'agit par exemple d'une batterie Lithium-Ion de tension à vide 400V (Volt).
- une deuxième module de puissance CONV qui est un module convertisseur hébergeant un convertisseur courant-continu - courant-continu, connecté d'une part à la batterie de traction et d'autre part au réseau de bord du véhicule. Il est permet ainsi d'alimenter les consommateurs du réseau de bord et éventuellement de recharger la batterie de servitude du véhicule ;
- un troisième module de puissance CAPA, qui est un module capacitif hébergeant une capacité de lissage. Cette capacité est connectée en parallèle entre la batterie de traction et le module onduleur OND, afin de filtrer le courant arrivant dans la batterie de traction notamment lorsque celle-ci est rechargée depuis un réseau d'alimentation électrique externe, le module onduleur OND faisant partie des composants d'un système de charge embarqué dans le véhicule.

Afin de limiter le nombre de barres bus connectées à la batterie, et de faire bénéficier au module convertisseur CONV du filtrage électromagnétique effectué par le module capacitif CAPA, la connexion du module convertisseur CONV à la batterie s'effectue au niveau de la même connexion que le module onduleur OND au module capacitif CAPA. Ainsi une barre bus BP parcourue par un courant positif, et une barre bus BN parcourue par un courant négatif sont connectées entre le module convertisseur CONV et le module onduleur OND.

Il est à noter que sur les **figures 1** **et** **2** les barres bus ne sont pas vissées et donc non connectées car les composants du système électronique de puissance ont été écartés les uns des autres pour plus de visibilité. De même les connexions positives et négatives du module capacitif CAPA ne sont pas visibles.

Le module capacitif CAPA comporte lui-même une connexion électrique en parallèle à la batterie de traction, et une connexion électrique en parallèle au module onduleur OND. Cette connexion électrique au module onduleur OND est formée de deux barres bus, une barre bus parcourue par un courant positif amenant le courant batterie, et une barre bus parcourue par un courant négatif ramenant le courant à la batterie. La barre bus parcourue par un courant positif est sensiblement parallèle à la barre bus BP et se connecte à l'onduleur OND par une même fixation vissée. La barre bus parcourue par un courant négatif est sensiblement parallèle à la barre bus BN et se connecte à l'onduleur OND par une même fixation vissée. Ces fixations vissées sont appelées bornier.

Les termes « sensiblement parallèle » signifient ici que les barres bus concernées se font face sur la largeur de leurs surfaces, leurs directions pouvant ne pas être exactement parallèles.

Cette utilisation d'un même bornier pour connecter électriquement le module capacitif CAPA, le module onduleur OND et le module convertisseur CONV, permet de gagner en compacité.

Selon l'invention, les barres bus BP et BN forment un ensemble ENS de barres bus et sont pliées de manière à former un U dans lequel est disposé le module capacitif CAPA. Afin d'empêcher les vibrations de cet ensemble ENS de barres bus BP et BN, parcouru par un courant haché lors du roulage du véhicule, une agrafe AG solidarise ces barres bus BP et BN au carter du module capacitif CAPA, ce qui permet de déplacer leur fréquence de résonance.

Cette agrafe AG préférentiellement en plastique comporte un simple insert en laiton, et est vissée par une vis VIS dans un bossage BOS formé sur le carter du module capacitif CAPA. Cette patte vissée prend en sandwich l'ensemble ENS de barres bus entre le carter du module capacitif CAPA et la patte vissée. L'isolation des barres bus est assurée par de simples blocs de mousse composite isolante MC1, MC2 et MC3.

Un premier bloc de mousse composite MC1, en forme de pavé droit de huit mm (millimètres) d'épaisseur avant compression, couvre toute la largeur de la barre bus BP, et est comprimé entre la patte vissée et la barre bus BP. Il est de préférence collé sur la barre bus BP avant son montage dans l'agrafe AG.

Un deuxième bloc de mousse composite MC2, en forme de pavé droit de huit mm (millimètres) d"épaisseur avant compression, couvre toute la largeur de la barre bus BP et de la barre bus BN, et est comprimé entre ces deux barres bus BP et BN, qui sont superposées au niveau de leur passage dans l'agrafe AG. Il est de préférence collé sur la barre bus BP ou BN avant son montage dans l'agrafe AG.

Enfin un troisième bloc de mousse composite MC3, en forme de pavé droit de huit mm (millimètres) d"épaisseur avant compression, couvre toute la largeur de la barre bus BN, et est comprimé entre la barre bus BN et le carter du module capacitif CAPA. Il est de préférence collé sur la barre bus BN avant son montage dans l'agrafe AG.

Les barres bus BP et BN sont superposées sur une longueur importante de l'ensemble ENS de barres bus afin de permettre de diminuer les courants parasites.

Il est à noter que d'autres modes de réalisation sont bien entendu possibles, notamment l'épaisseur des blocs de mousse composite est en variante légèrement inférieure à 8mm d'épaisseur ou bien plus importante. La patte vissée peut être également conçue dans une autre matière que du plastique, par exemple elle peut être en acier. De même les connexions entre les modules de puissance sont en variante différentes, par exemple dans une variante de réalisation, l'onduleur et la capacité de lissage sont connectées sur le même bornier à un autre module de puissance qu'un convertisseur de courant, par exemple un compresseur de climatisation.

## Revendications

1. Système d'électronique de puissance pour groupe motopropulseur électrique, comportant :
- un premier module (OND) d'électronique de puissance
- un deuxième module (CONV) d'électronique de puissance,
- un troisième module (CAPA) d'électronique de puissance,
- un ensemble (ENS) de barres bus (BP, BN) connectant ledit premier module (OND) audit deuxième module (CONV), ledit ensemble (ENS) de barres bus (BP, BN) comportant une déviation en forme de U fixée au carter dudit troisième module (CAPA) par une agrafe (AG) vissée,
ledit système étant **caractérisé en ce que** ladite déviation en forme de U est prise en sandwich entre ledit carter dudit troisième module (CAPA) et ladite agrafe (AG), seul un bloc de mousse composite isolante (MC3) séparant ledit carter dudit ensemble de barres bus.

2. Système d'électronique de puissance selon la revendication 1, **caractérisé en ce que** ladite agrafe (AG) est une patte en plastique avec un insert en laiton fixée par vissage sur un bossage (BOS) dudit carter, ladite patte étant seulement isolée dudit ensemble (ENS) de barres bus (BP, BN) par un bloc de mousse composite isolante (MC1).

3. Système d'électronique de puissance selon la revendication 1 ou 2, **caractérisé en ce que** ledit ensemble (ENS) de barres bus (BP, BN) comporte une barre bus (BP) parcourue par un courant positif et une barre bus (BN) parcourue par un courant négatif superposées au niveau de ladite agrafe 5AG), et séparées par un bloc de mousse composite isolante (MC2).

4. Système d'électronique de puissance selon l'une quelconque des revendications 1 à 3, **caractérisé en ce que** ledit troisième module (CAPA) est disposé dans le U et comporte une connexion électrique formée de deux barres bus sensiblement parallèles à l'une des pattes dudit U, ladite connexion électrique venant se connecter sur le même bornier que ledit premier module (OND) ou ledit deuxième module (CONV).

5. Système d'électronique de puissance selon l'une quelconque des revendications 1 à 4, **caractérisé en ce que** le premier module (OND) est un module onduleur, le deuxième module (CONV) est un module de conversion courant continu - courant continu, et le troisième module (CAPA) est un module capacitif hébergeant une capacité de lissage destinée à être connectée aux bornes d'une batterie dudit groupe motopropulseur électrique.

## Patentansprüche

1. Leistungselektroniksystem für eine elektrische Antriebseinheit, das aufweist:
- ein erstes Leistungselektronikmodul (OND),
- ein zweites Leistungselektronikmodul (CONV),
- ein drittes Leistungselektronikmodul (CAPA),
- eine Einheit (ENS) von Sammelschienen (BP, BN), die das erste Modul (OND) mit dem zweiten Modul (CONV) verbindet, wobei die Einheit (ENS) von Sammelschienen (BP, BN) eine U-förmige Umleitung aufweist, die am Gehäuse des dritten Moduls (CAPA) durch eine geschraubte Klammer (AG) befestigt ist,
wobei das System **dadurch gekennzeichnet ist, dass** die U-förmige Umleitung zwischen dem Gehäuse des dritten Moduls (CAPA) und der Klammer (AG) sandwichartig eingeklemmt ist, wobei nur ein isolierender Verbundschaumstoffblock (MC3) das Gehäuse von der Einheit von Sammelschienen trennt.

2. Leistungselektroniksystem nach Anspruch 1, **dadurch gekennzeichnet, dass** die Klammer (AG) eine Kunststofflasche mit einem Einsatz aus Messing ist, die durch Schraubverbindung an einer Wölbung (BOS) des Gehäuses befestigt ist, wobei die Lasche nur durch einen isolierenden Verbundschaumstoffblock (MC1) von der Einheit (ENS) von Sammelschienen (BP, BN) getrennt ist.

3. Leistungselektroniksystem nach Anspruch 1 oder 2, **dadurch gekennzeichnet, dass** die Einheit (ENS) von Sammelschienen (BP, BN) eine von einem positiven Strom durchflossene Sammelschiene (BP) und eine von einem negativen Strom durchflossene Sammelschiene (BN) aufweist, die im Bereich der Klammer 5AG) übereinander angeordnet und durch einen isolierenden Verbundschaumstoffblock (MC2) getrennt sind.

4. Leistungselektroniksystem nach einem der Ansprüche 1 bis 3, **dadurch gekennzeichnet, dass** das dritte Modul (CAPA) in dem U angeordnet ist und eine elektrische Verbindung aufweist, die von zwei Sammelschienen im Wesentlichen parallel zu einem der Schenkel des U gebildet wird, wobei die elektrische Verbindung sich mit der gleichen Klemmenleiste wie das erste (OND) oder das zweite Modul (CONV) verbindet.

5. Leistungselektroniksystem nach einem der Ansprüche 1 bis 4, **dadurch gekennzeichnet, dass** das erste Modul (OND) ein Wechselrichtermodul ist, das zweite Modul (CONV) ein Gleichstrom-Gleichstrom-Wandlermodul ist, und das dritte Modul (CAPA) ein kapazitives Modul ist, in dem ein Glättungskondensator untergebracht ist, der dazu bestimmt ist, mit den Klemmen einer Batterie der elektrischen Antriebseinheit verbunden zu werden.

## Claims

1. Power electronic system for an electric powertrain, including:
- a first power electronic module (OND);
- a second power electronic module (CONV);
- a third power electronic module (CAPA);
- a set (ENS) of busbars (BP, BN) connecting said first module (OND) to said second module (CONV), said set (ENS) of busbars (BP, BN) including a U-shaped deviation that is attached to the casing of said third module (CAPA) via a bolted fastener (AG), said system being **characterized in that** said U-shaped deviation is sandwiched between said casing of said third module (CAPA) and said fastener (AG), with just a block of insulating composite foam (MC3) separating said casing from said set of busbars.

2. Power electronic system according to Claim 1, **characterized in that** said fastener (AG) is a lug made of plastic with an insert made of brass, which lug is attached by bolted connection to a boss (BOS) on said casing, said lug being insulated from said set (ENS) of busbars (BP, BN) just by a block of insulating composite foam (MC1).

3. Power electronic system according to Claim 1 or 2, **characterized in that** said set (ENS) of busbars (BP, BN) includes a busbar (BP) through which a positive current flows and a busbar (BN) through which a negative current flows which are superposed at the site of said fastener 5AG) and are separated by a block of insulating composite foam (MC2).

4. Power electronic system according to any one of Claims 1 to 3, **characterized in that** said third module (CAPA) is positioned within the U and includes an electrical connection formed of two busbars that are substantially parallel to one of the arms of said U, said electrical connection being connected to the same terminal block as said first module (OND) or said second module (CONV).

5. Power electronic system according to any one of Claims 1 to 4, **characterized in that** the first module (OND) is an inverter module, the second module (CONV) is a DC-to-DC converter module and the third module (CAPA) is a capacitor module housing a smoothing capacitor that is intended to be connected to the terminals of a battery of said electric powertrain.
